Europäisches Patentamt

European Patent Office

Office européen des brevets

(11) Publication number: **0 029 367**
**B1**

(12) **EUROPEAN PATENT SPECIFICATION**

(45) Date of publication of patent specification: **05.03.86**

(21) Application number: **80304112.8**

(22) Date of filing: **14.11.80**

(51) Int. Cl.⁴: **H 01 L 27/14, H 04 N 3/14**

(54) **Solid state imaging apparatus.**

(30) Priority: **16.11.79 JP 149375/79**
**16.11.79 JP 149376/79**
**16.11.79 JP 149378/79**

(43) Date of publication of application:
**27.05.81 Bulletin 81/21**

(45) Publication of the grant of the patent:
**05.03.86 Bulletin 86/10**

(84) Designated Contracting States:.
**DE FR GB**

(56) References cited:
**GB-A-2 014 783**
**US-A-3 946 223**
**US-A-4 271 420**

(73) Proprietor: **Matsushita Electric Industrial Co., Ltd.**
**1006, Oaza Kadoma**
**Kadoma-shi Osaka-fu, 571 (JP)**

(72) Inventor: **Ohta, Yohio**
**92 Nishimasashi Zenpouji**
**Amagasaki-shi (JP)**

(74) Representative: **Crawford, Andrew Birkby et al**
**A.A. THORNTON & CO. Northumberland House**
**303-306 High Holborn**
**London WC1V 7LE (GB)**

Courier Press, Leamington Spa, England.

## Description

This invention relates to a solid state imaging apparatus which stores charges in proportion to intensity of incident light and produces a sequential video signal.

As is well known, it is preferable to use a solid state area imaging device for a television camera in place of a pick up tube for converting an optical image of an object to an electrical video signal, in cases where compact size, long life, stability and lower power consumption, are required. However, there remain problems in utilizing such a device as a practical imaging apparatus.

One of the typical problems is a phenomenon known as blooming. Blooming is especially objectionable in imaging devices with high sensitivity, since even a normal light source causes overload at high light portions in a low-light-level environment. Blooming is caused by excess charges generated in a photosensor such as a photodiode. To make such solid state imaging apparatus capable of operating without blooming in the presence of excessive high light portions, several methods of suppressing blooming have been proposed.

One of the practical methods employs OFD (Over Flow Drain) within the image sensor to absorb excess charges, as shown in Bell Syst. Tech. Journal, Vol. 51, pp. 1923—1926, 1972. But this method has several problems.

The first problem is the limitation of blooming suppression due to the limitation of OFD's space in the imaging area. The reason thereof is that quantity of excess charge absorption is mainly proportional to area of OFD. The second problem is the decrement of the sensitivity of the imaging apparatus, because of the decrement of the effective area of photosensor due to the existence of OFD.

Another practical method for suppressing blooming is providing an n-p-n structure in the imaging area so as to absorb excess charges into the n-type substrate forming part of the n-p-n structure, such as shown in ISSCC (International Solid-State Circuit Conference) Dig. of Tech. Papers, pp. 192—193, Feb. 1972. This technique has problems, for example, the effect of blooming suppression is not so high because of the spreading of generated excess charges through the n-type substrate of the n-p-n structure into adjacent regions.

Our United Kingdom Patent Application GB—A—2,014,783 discloses a solid state image sensor having a plurality of cells each of which comprises a photosensitive element and a switching element connected to the photosensitive element for reading out charge signals from the photosensitive element under the control of a read pulse. Blooming suppression is provided by applying a biasing voltage across each cell such that the potential of the photosensitive element will not drop below the level of the biasing voltage even when a light amount of light is incident thereon.

According to the present invention, a solid state imaging apparatus having a substrate and a plurality of cells formed on the substrate, which accumulate charge signals in response to an intensity of an incident light from an object and producing a video signal representing an optical image of the object, by reading the charge signals from said cells, in which each of said cell comprises a photosensitive element (DN) and a switching element (TR) which is connected to said photosensitive element and reads out the charge signals therefrom under the control of a read pulse ($\phi$R), characterised by further comprising means adapted to supply a blooming suppression pulse ($\phi$BS) to the connection point of said photosensitive element (DN) and the switching element (TR) through a capacitive coupling, the blooming suppression pulse ($\phi$BS) being in synchronism with said read pulse ($\phi$R).

According to an embodiment of the invention there is provided a plurality of pairs of a first diode and a switching transistor formed in matrix, a plurality of second diodes respectively coupled to the first diodes, one of which first diode and second diode is a photodiode, and a bias voltage including a blooming suppression pulse is supplied to each one of the first and second diodes. Each connection point of the first and second diodes is clamped at the bias voltage when an accumulated charge signal is about to exceed a predetermined amount due to a large intensity light.

Preferably, the apparatus utilizes a photodiode array, an MOS transistor array, a charge transfer device such as a CCD (Charge Coupled Device) and a BBD (Bucket Brigade Device) or a combination thereof.

An advantage of the present invention is that blooming is satisfactorily suppressed without decreasing the sensitivity of the apparatus. Further, it is possible to read video signals from its imaging area with low power consumption and with large dynamic range.

In order that the present invention be more readily understood embodiments thereof will now be described by way of example with reference to the accompanying drawings, in which:—

Figure 1 is a sectional view of a solid state imaging apparatus according to the present invention;

Figure 2 is a schematic diagram illustrating an equivalent circuit of the apparatus shown in Figure 1;

Figures 3A, 3B, 3C and 3D are diagrams showing wave forms for describing the operation of the embodiment of Figure 1;

Figure 4 is a graph illustrating an effect of suppressing blooming according to the embodiment of Figure 1;

Figures 5A and 5B are a sectional view showing another embodiment of the invention and an equivalent circuit diagram thereof, respectively;

Figures 6A and 6B are a sectional view showing a further embodiment of the invention and an equivalent circuit diagram thereof, respectively; and

Figure 7 is a diagram showing a wave form for describing the operation of a further embodiment of the invention.

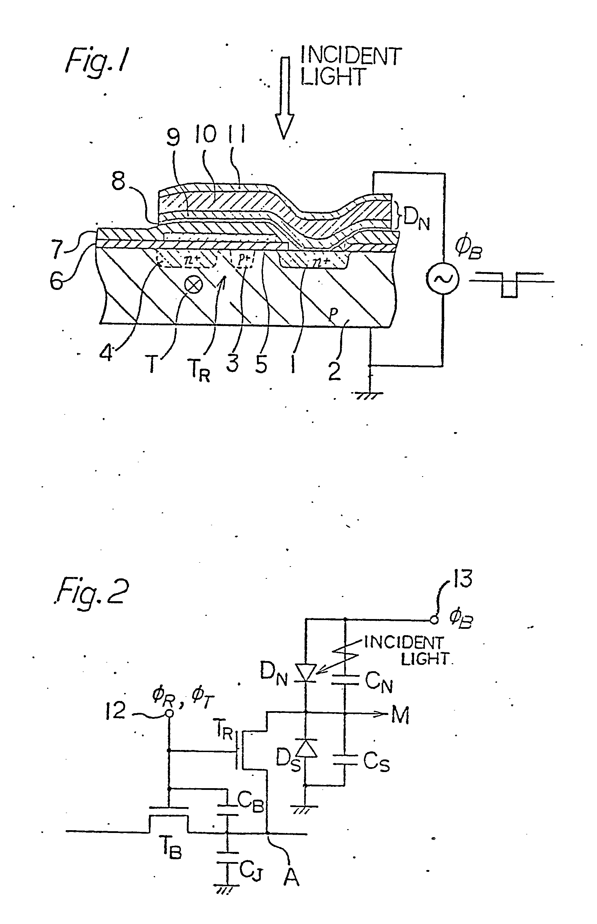

Figure 1 and Figure 2 show one cell forming part of the imaging area of one embodiment of a solid state imaging apparatus according to this invention. The cell includes a p-n hetero junction photoconductor $D_N$, a diode $D_S$, a read-gate FET $T_R$ and a BBD gate FET $T_B$. The diode $D_S$ is constructed by forming an $n^+$ type diffused region 1 in a p-type substrate 2, which diffused region 1 also constitutes a drain region of the read-gate FET $T_R$. A $p^+$ region 3 operates as a potential barrier for preventing an injection of electrons from the $n^+$ region 1 to an $n^+$ region 4 which constitutes a source region of the read-gate FET $T_R$. The $p^+$ region 3 is provided only in the case where vertical scanning shift registers for transferring signal charges from imaging cells to an output horizontal register consist of CCDs. In case that the vertical scanning shift registers are constituted by BBDs, the $n^+$ type region 4 is constructed in the substrate as shown in the said figure. Since the transfer function of CCDs and the BBDs is substantially same, the operation of the embodiment of this invention is described as follows in case of utilizing BBDs.

A first gate electrode 5 has an overlapping area with the $n^+$ type region 4. A gate oxide layer 6 insulates the first gate electrode 5 from the substrate 2. An insulator 7 is formed on the first gate electrode 5 and insulates a first metal electrode 8 from the first gate electrode 5 and the substrate 2. The electrode 8 is in contact with $n^+$ type region 1, and is utilized as cathode electrodes of diode $D_S$ and the p-n heterojunction photoconductor $D_N$ constructed with, for example, ZnSe 9 and $Zn_{1-x}Cd_xTe$ 10. A transparent electrode 11 is deposited on the photoconductor $D_N$. A symbol T represents the direction of the signal charge transfer through the vertical scanning shift register.

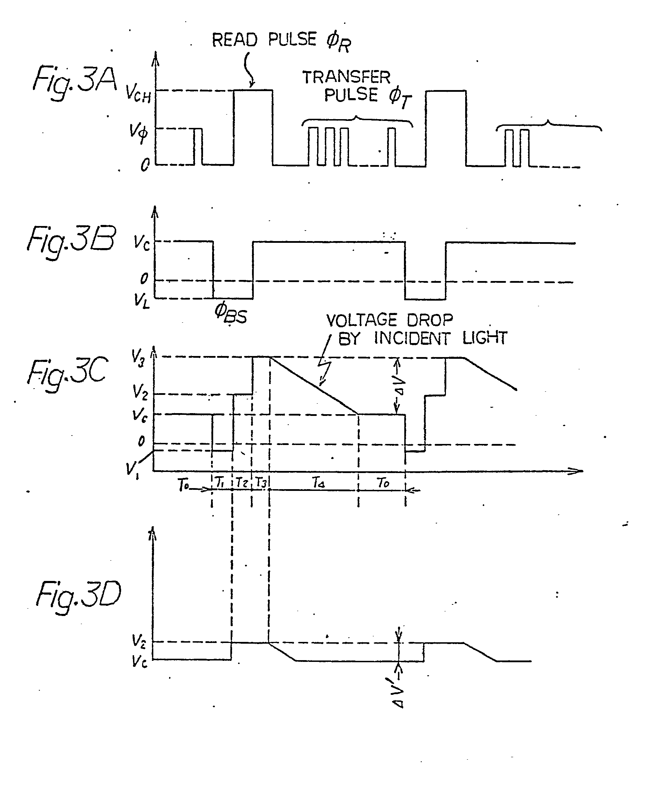

Fig. 2 is an equivalent circuit of the cell shown in Fig. 1. A numeral 12 represents terminal for supplying a read pulse $\phi_R$ and transfer pulse $\phi_T$ such as shown in Fig. 3A to the first gate electrode 5 of the transistors $T_R$ and $T_B$. A symbol $C_B$ represents a capacitance of a bucket for constructing BBD and Cj a junction capacitance. The cathode electrode of the photoconductor $D_N$ and the diode $D_S$ are connected with each other at a node M. Symbols $C_N$ and $C_S$ represent equivalent capacitance of the photoconductor $D_N$ and the diode $D_S$, respectively. A numeral 13 is an input terminal which corresponds to the transparent electrode 11 in Fig. 1, and to which a bias voltage $\phi_B$ such as shown in Fig. 3B is supplied.

In this embodiment, the bias voltage $\phi B$ includes a blooming suppression pulse $\phi_{BS}$ which is in synchronism with the read pulse $\phi_R$ supplied to the input terminal . The operation of the above mentioned embodiment is described hereinafter.

Fig. 3A is a diagram showing the wave, form of a clock pulse $\phi$ composed of the read pulse $\phi_R$ for reading signal charges from picture elements, i.e. photoconductors $D_N$, and the transfer pulse $\phi_T$ for transferring the signal charges. The voltages of the read pulse $\phi_R$ and the transfer pulse $\phi_T$ and $V_{CH}$ and $V_\phi$, respectively. Fig. 3B is a diagram showing the wave form of the bias voltage $\phi_B$ which includes the blooming suppression pulse $\phi_{BS}$. The bias level of the bias voltage $\phi_B$ is $V_C$ with the positive polarity and the voltage of the blooming suppression pulse $\phi_{BS}$ is $V_L$ with the negative polarity.

With the application of the clock pulse $\phi$ and the bias voltage $\phi_B$ to the terminals 12 and 13, respectively, the potential of the node M in Fig. 2 changes such as shown by wave form of Fig. 3C. The operation of the apparatus of this embodiment is described in detail at respective periods $T_1—T_4$ of Fig. 3C as follows.

(i) Period $T_1$

When the voltage of the terminal 13 changes from $V_C$ to $T_L$ in response to the blooming suppression pulse $\phi_{BS}$ at the beginning of the period $T_1$, the potential of the node M changes to $v_1$ such as determined by the formula:

$$V \cdot C_S = (v_1 - V_L) \cdot C_N + v_1 \cdot C_S$$

where V represents the voltage of the node M at the end of the preceding period $T_0$. Therefore, $v_1$ is expressed by

$$v_1 = \frac{V \cdot C_S + V_L \cdot C_N}{C_N + C_S} \qquad (1)$$

Assuming the node M has been clamped at the voltage level $V_C$ due to large intensity light in the preceding period $T_0$, such as shown in Fig. 3C, V is equal to $V_C$. Then $v_1$ becomes $V_1$ such as expressed by

$$V_1 = \frac{V_C \cdot C_S + V_L \cdot C_N}{C_N + C_S} \qquad (2)$$

(ii) Period $T_2$

At the beginning of the period $T_2$, the read pulse $\phi_R$ is supplied to the terminal 12. The voltage $V_{CH}$ of the read pulse $\phi_R$ is divided by capacitances $C_B$ and Cj, and the divided voltage is applied to the node A of the transfer stage $T_B$. At this instant, the potential of the node A changes from $V_R$ to $V_h$, such as expressed as follows.

$$V_h = V_R + \frac{C_B}{C_B + C_j} \cdot V_{CH} \qquad (3)$$

where $V_R$ is the preceding potential of the node A, which is set up by transfer pulse $\phi_T$ and expressed as $V_R = V_\phi - V_{TB}$, $V_{TB}$: the threshold voltage of the FET $T_B$. With the read pulse $\phi_R$, the gate FET $T_R$ is on, and charges the amount of which is in proportion to the intensity of the light are transferred into the node M from the node A, in other words signal charges are read out through the FET $T_R$ into the capacitor $C_B$. As a result of the potential of node M rises to the cut-off voltage of the FET $T_R$. The cutoff voltage $V_2$ is expressed as:

$$V_2 = V_h - V_{TC} - K_{SB} \qquad (4)$$

where $V_{TC}$ is the threshold voltage of the read gate FET $T_R$, and $K_{SB}$ is an increased component of the threshold voltage by a substrate bias effect.

From the expressions (3) and (4), $V_2$ is given as follows:

$$V_2 = (V_\phi - V_{TB}) + \frac{C_B}{C_B + C_j} \cdot V_{CH} - V_{TC} - K_{SB} \qquad (5)$$

This voltage $V_2$ is, therefore, constant.

In this state, charges $Q_M$ stored in the capacitors $C_N$ and $C_S$ is expressed by:

$$Q_M = (V_2 - V_L) \cdot C_N + V_2 \cdot C_S \qquad (6)$$

(iii) Period $T_3$

At the beginning of the period $T_3$, the potential of the terminal 13 changes from $V_L$ to $V_C$, and so the potential of the node M rises from $V_2$ to $V_3$ because of the capacitive coupling by the junction capacitance $C_N$. The voltage $V_3$ is defined by the following equation:

$$Q_M = (V_3 - V_C) \cdot C_N + V_3 \cdot C_S \qquad (7)$$

Therefore, from the equations (6) and (7), the potential $V_3$ is given by:

$$V_3 = V_2 + \frac{C_N}{C_N + C_S} \cdot (V_C - V_L) \qquad (8)$$

If, in a practical embodiment, the capacitances and the voltages are selected, such as:

$C_B = 0.1$ pF, $C_j = 0.03$ pF, $C_N = 0.06$ pF,
$C_S = 0.03$ pF, $V_C = 7$V, $V_L = -5$V,
$V_\phi = 8$ V, $V_{TB} = 1$ V, $V_{CH} = 14$ V,
$V_{TC} = 3$ V, $V_{SB} = 6$ V,

$V_1$, $V_2$ and $V_3$ are given as follows:

$V_1 = -1.0$ V
$V_2 = 8.7$ V
$V_3 = 16.7$ V

(iv) Period $T_4$

In this period, the signal charges read out into the capacitor $C_B$ during the read pulse period and temporarily stored therein are transferred out through the vertical scanning shift register in the direction T in Fig. 1 under the control of the transfer clock pulse $\phi_T$. On the other hand, the potential of the node M diminishes in proportion to the intensity of the incident light upon the photoconductor $D_N$. Even if the intensity of the incident light is excessively large, such as in this case, the potential of the node M does not decrease to below $V_C$, because the node M is clamped at the bias level $V_C$ by the heterojunction photoconductor $D_N$, when the potential thereof is about to exceed the potential $V_C$. As a result the excess charge is removed through the electrode 11 and the terminal 13, so that the excess signal charges are not diffused into the substrate, and therefore the blooming phenomenon is remarkably suppressed.

The voltage $V_C$ is selected to a certain level which is higher than the voltage of the transfer pulse $\phi_T$ so that the signal charges are not read out by the transfer pulse $\phi_T$ through the read gate FET $T_R$. If the voltage $V_C$ is high, the effect of blooming suppression becomes large but the dynamic range of the imaging apparatus becomes small. Therefore the amplitude of the voltage $V_C$ should be selected preferably in consideration of it.

The dynamic range of the imaging apparatus is decided by the voltage difference $\Delta V$, i.e. the saturation signal voltage, such as given by:

$$\Delta V = V_3 - V_C \qquad (9)$$

The signal charges representing the total amount of the incident light during one charge accumulation period, that is almost one field or frame period of the conventional solid state imaging apparatus, are read out by the read pulse $\phi_R$ through the read gate FET $T_R$ into the vertical transfer channel.

According to this embodiment, in the period $T_3$, the voltage

$$\frac{C_N}{C_N + C_S} \cdot (VC - V_L)$$

is added to the potential $V_2$ of the node M. Therefore the dynamic range is enlarged with such increment in the potential of the node M. It means that the range operable without blooming is enlarged. In the case when the values of the capacitances and the voltages are given such as mentioned above, the saturation signal voltage $\Delta V$ is given from the formula (9) as

$$\begin{aligned} \Delta V &= V_3 - V_C \\ &= 16.7 - 7.0 V \\ &= 9.7 \ V \qquad (10) \end{aligned}$$

On the other hand, when the blooming suppression pulse $\phi_{BS}$ is not supplied to the electrode 11 as illustrated in Fig. 3D, the saturation signal voltage $\Delta V'$ is given as

$$\begin{aligned} V' &= V_2 - V_C \qquad (11) \\ &= 2.7 \ V \end{aligned}$$

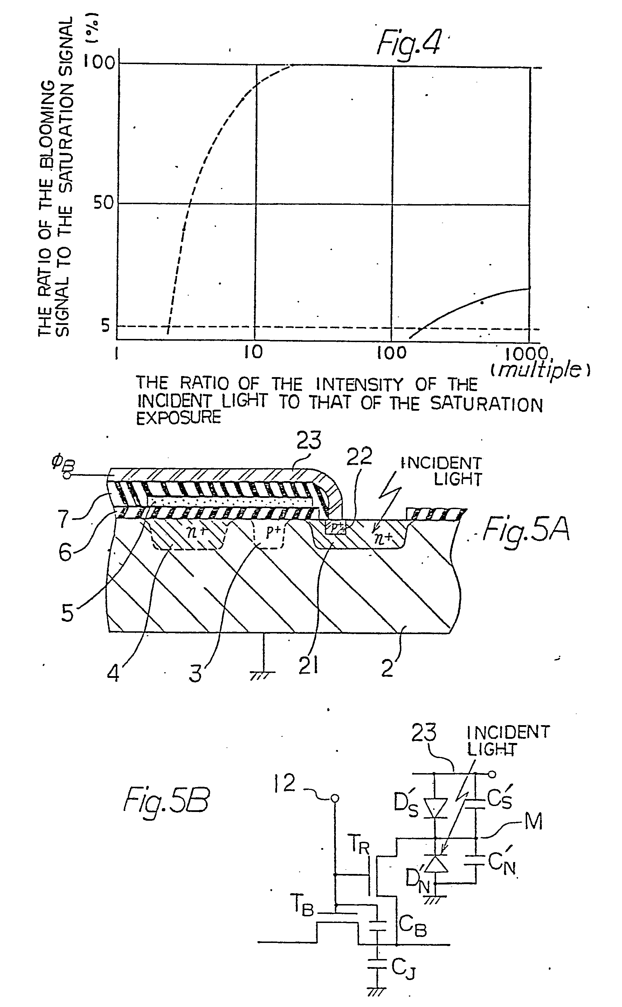

It is obvious from the expressions (10) and (11), that according to this embodiment the dynamic range is enlarged by $V_3-V_2$, that is 7 volts, with respect to the latter apparatus. The experimental data representing blooming suppression characteristics of the embodiment described above are shown in Fig. 4. In the same figure, the abscissa axis represents the intenity of the incident light which is expressed as a multiple of a saturation exposure, and the ordinate axis represents the ratio of the blooming signal to the saturation signal in a percent expression. In this case, the amount of the blooming signal is defined as the amount of quasi-output signal which is generated in the direction of the vertical transfer in the imaging apparatus when the signal charges are read out from the black back ground surrounding the white spot which is located at the center of the imaging area. The amount of the saturation signal is defined as the amount of the output signal read out from the white spot. In the same figure, the dotted curve represents a characteristic of the conventional case where the blooming suppression pulse is not supplied, and the real curved line represents a characteristic of the embodiment of this invention. As is evident from the Fig. 4, if the limit of the allowable blooming signal rates is 5%, the apparatus of this embodiment has the effect of suppression against the light having the intensity more than a hundred times as large as that of the saturation exposure. On the other hand, the conventional apparatus has the effect against the light having the intensity less than the intensity which is twice as large as that of the saturation exposure.

Figs. 5A and 5B show a cell structure of another embodiment of the invention and the equivalent circuit thereof, respectively. The difference of this embodiment with respect to the previous embodiment of Figs. 1 and 2 exists in a construction of a photosensitive element $D_N'$ and a diode $D_S'$. In this embodiment, the diode $D_S'$ and the photodiode $D_N'$ are utilized in place of the heterojunction photoconductor $D_N$ and the diode $D_S$ shown in Fig. 2, respectively. In Fig. 5A, 21 is an $n^+$ diffused region formed in the substrate 2 of p type semiconductor. The photodiode $D_N$ is constructed by the $n^+$ region 21 and the substrate 2. A $p^+$ diffused region 22 is provided in the $n^+$ region 21, so as to construct the diode $D_S'$ in combination with the $n^+$ diffused region 21. The $p^+$ region 22 is connected electrically to an electrode 23. In the equivalent circuit of Fig. 5B, $C_S'$ is the junction capacitance of the diode $D_S'$ and $C_N'$ is that of the diode $D_N'$. In Figs. 5A and 5B, the constructions of the portions represented by the same symbols as those in Figs. 1 and 2 are the same as those in Figs. 1 and 2. In the solid state imaging apparatus of this embodiment, the bias voltage $\phi_B$ including blooming suppression pulse $\phi_{BS}$ shown in Fig. 3B is supplied to the terminal of the electrode 23. with respect to blooming suppression the function of this embodiment is similar to that of the preceding embodiment of Figs and 2. It is well understood from Figs. 3A, 3B, 3C and 3D, and the description thereof. Although the heterojunction photoconductor $D_N$ or the

diode $D_S'$ is utilized as the element through which the bias voltage is supplied in the above mentioned embodiments, it is not essential for the invention. It is also possible to utilize a capacitor in place of such element.

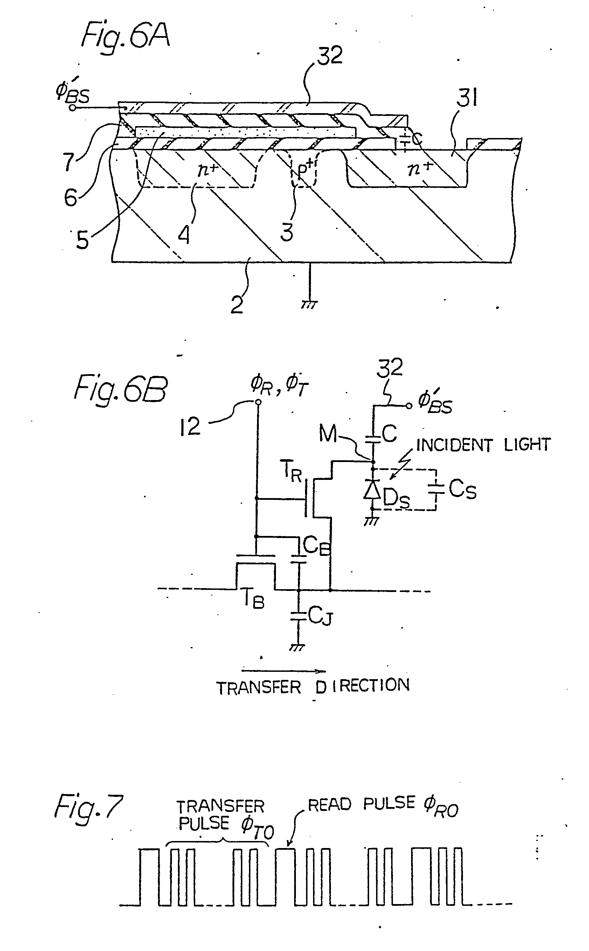

Figs. 6A and 6B illustrate a further embodiment employing such construction. Fig. 6A shows a cell structure of this embodiment, and Fig. 6B the equivalent circuit thereof. In these figures, the elements with the same symbols as in Figs. 1A and 1B have the same construction as those in Figs. 1A and 1B. A numeral 31 in Fig. 6A is an $n^+$ diffused region such as the region 1 in Fig. 1. An electrode 32 is formed on the insulating layer 7 so that it has an overlapping portion in part with the $n^+$ diffused region 31. The $n^+$ region 31, the oxide layer 6, the insulating layer 7, and the electrode 32 constitute a capacitor C. A wave form of a blooming suppression pulse which is supplied to the electrode 32 is almost similar to that of the bias voltage $\phi_{BS}$ except it does not include a DC level. Therefore, the operation of this embodiment is almost the same as those of the preceding embodiments except that the node M is not clamped at a certain voltage level in the accumulation period $T_4$. Only the dynamic range of the imaging apparatus is enlarged in this case. That is to say, the potential of the node M rised by

$$\frac{C}{C+C_S} \cdot (V_C-V_L)$$

in this apparatus when the blooming suppression pulse is supplied to the electrode 32. The increment of the node potential corresponds to that in the embodiment of Figs. 1 and 2, that is

$$\frac{C_N}{C_N+C_S} \cdot (V_C-V_L).$$

Therefore, the allowable range of the amount of the incident light, in which the apparatus is operable without blooming is enlarged.

Fig. 7 represents a clock pulse $\phi_O$ of a further embodiment in which lower power consumption is obtained. The construction thereof may be the same as that of Fig. 1 and a bias voltage is also the same as Fig. 3B. The feature of this embodiment exist in the clock pulse $\phi_O$ in which the amplitude of the read pulse $\phi_{RO}$ is smaller than that of the embodiment of Fig. 1 so as to be almost equal to the amplitude of the transfer pulse $\phi_{TO}$. This feature, makes it possible to realize the imaging apparatus with lower power consumption. In spite that the read pulse $\phi_{RO}$ has such a small amplitude, the enough dynamic range of the apparatus is obtained by selecting the amplitude of the blooming suppression pulse $\phi_{BS}$ preferably.

Although this invention is described in reference to the apparatus employing the interline transfer method, it is not essential for the invention. It is possible to apply this invention to apparatuses employing other method such as the frame transfer method, and also to a linear imaging apparatus.

It is obvious that this invention is also applicable to the imaging apparatus which operates in an interlace mode, though the above-disclosure refers only to non-interlace imaging apparatus for the simplicity.

## Claims

1. A solid state imaging apparatus having a substrate and a plurality of cells formed on the substrate, which accumulate charge signals in response to an intensity of an incident light from an object and producing a video signal representing an optical image of the object, by reading the charge signals form said cells, in which each of said cell comprises a photosensitive element (DN) and a switching element (TR) which is connected to said photosensitive element and reads out the charge signals therefrom under the control of a read pulse ($\phi$R), characterised by, further comprising means adapted to supply a blooming suppression pulse ($\phi$BS) to the connection point of said photosensitive element (DN) and the switching element (TR) through a capacitive coupling, the blooming suppression pulse ($\phi$BS) being in synchronism with said read pulse ($\phi$R).

2. A solid state imaging apparatus as claimed in claim 1, wherein said photosensitive element comprises a heterojunction photoconductor which also constitutes said capacitive coupling.

3. A solid state imaging apparatus as claimed in claim 1, wherein said capacitive coupling is constituted by a capacitor (C) coupling the connection point to said electrode.

4. A solid state imaging apparatus as claimed in claim 1, 2 or 3, wherein said switching element (TR) comprises a FET.

5. A solid state imaging apparatus as claimed in claim 1, wherein said photosensitive element (DN) comprises a first diode which has a junction capacitance and accumulates the charge signals therein;

and wherein a second diode which has a junction capacitance therein is connected to the connection point of said first diode and said switching element;

the blooming suppression pulse supplying means being arranged to supply a bias voltage which includes the blooming suppression pulse to one of said first and second diodes.

6. A solid state imaging apparatus as claimed in claim 5, wherein said first diode comprises arises a heterojunction photoconductor.

7. A solid state imaging apparatus as claimed in claim 5 or 6, wherein said bias voltage has a predetermined voltage level except in the interval of said blooming suppression pulse, and the connection point of said first and second diodes is clamped at a voltage level decided by the predetermined voltage level when the intensity of the incident light exceeds a predetermined amount.

8. A solid state imaging apparatus as claimed in claim 5, wherein said cell further comprises:

a temporary storage region for temporary storing said charge signals read out through said switching element from said first diode; and

a transfer element having an electrode for transferring out the charge signals from said temporary storage region for producing the video signal under the control of a transfer pulse provided to the electrode which is coupled to the control electrode of said switching element.

9. A solid state imaging apparatus as claimed in claim 8, wherein the amplitude of said read pulse is larger than that of said transfer pulse.

10. A solid state imaging apparatus as claimed in claim 8, wherein the amplitude of said read pulse is equal to that of said transfer pulse.

11. A solid state imaging apparatus as claimed in claim 8, 9 or 10, wherein the level of the bias voltage is larger than that of said transfer pulse and the connection point of said first diode and said switching element is clamped at a predetermined voltage level decided by said bias voltage when the intensity of the incident light is about to exceed a predetermined amount.

12. A solid state imaging apparatus according to any one of claims 5 to 11,

wherein the first diode is constituted by a diffused region which is formed in a semiconductor substrate and has an opposite conductivity characteristic with respect to that of said substrate;

and the second diode is constituted by another region which is formed in or upon said diffused region;

the read pulse being supplied by a gate electrode means which is provided on an insulating layer formed on said substrate and reads out charge signals which is accumulated in one of said first and second diode and the amount of which is in proportion to the amount of the incident light; and

the bias voltage being supplied by a further electrode electrically coupled to said other region.

13. A solid state imaging apparatus as claimed in claim 12, wherein said other region comprises a heterojunction photoconductor formed upon said diffused region for accumulating the charge signals.

14. A solid state imaging apparatus as claimed in claim 12, wherein said other region comprises a second diffused region which is formed in said diffused region and has an opposite conductivity characteristic with respect to that of said diffused region to form the second diode.

15. A solid state imaging apparatus as claimed in claim 12, 13 or 14, wherein the potential of said diffused region is clamped at a predetermined level decided by the level of said bias voltage when the amount of the incident light is about to exceed a predetermined amount.

## Patentansprüche

1. Festkörper-Bildaufnahmeapparat mit einem Substrat und einer Vielzahl von Zellen, die auf dem Substrat ausgebildet sind, die Ladungssignale in Abhängigkeit von einer Intensität von einem Objekt einfallenden Lichts ansammeln und ein Videosignal erzeugen, das ein optisches Abbild des Objekts darstellt, indem die Ladungssignale von den Zellen gelesen werden, wobei jede der Zellen ein photoempfindliches Element (DN) und ein Schalterelement (TR) enthält, das mit dem photoempfindlichen Element verbunden ist und die Ladungssignale daraus unter Steuerung durch einen Leseimpuls (φR) ausliest, dadurch gekennzeichnet, daß es weiterhin eine Einrichtung enthält, die dazu eingerichtet ist, einen Überstrahlungsunterdrückgsimpuls (φBS) zum Verbindungspunkt des photoempfindlichen Elements (DN) mit dem Schalterelement (TR) über eine kapazitive Verbindung zu liefern, wobei der Überstrahlungsunterdrücksimpuls (φBS) mit dem Leseimpuls (αR) synchron ist.

2. Festkörper-Bildaufnahmeapparat nach Anspruch 1, bei dem das photoempfindliche Element einen Heterojunction-Photoleiter enthält, der auch die kapazitive Verbindung bildet.

3. Festkörper-Bildaufnahmeapparat nach Anspruch 1, bei dem die kapazitive Verbindung von einem Kondensator (C) gebildet wird, der den Verbindungspunkt mit der Elektrode verbindet.

4. Festkörper-Bildaufnahmeapparat nach Anspruch 1, 2 oder 3, bei dem das Schalterelement (TR) einen FET enthält.

5. Festkörper-Bildaufnahmeapparat nach Anspruch 1, bei dem das photoempfindliche Element (DN) eine erste Diode enthält, die eine Verbindungskapazität aufweist und die Ladungssignale darin speichert;

und wobei eine zweite Diode, die eine Verbindungskapazität darin aufweist, mit dem Verbindungspunkt der ersten Diode mit dem Schalterelement verbunden ist;

die Überstrahlungsunterdrücksimpuls-Zuführeinrichtung dazu eingerichtet ist, eine Vorspannung zu einer der ersten und zweiten Dioden zu liefern, die den Überstrahlungsunterdrückungsimpuls enthält.

6. Festkörper-Bildaufnahmeapparat nach Anspruch 5, bei dem die erste Diode einen Heterojunction-Photoleiter enthält.

7. Festkörper-Bildaufnahmeapparat nach Anspruch 5 oder 6, bei dem die Vorspannung einen vorbestimmten Spannungspegel mit Ausnahme in dem Intervall des Überstrahlungsunterdrückungsimpulses aufweist, und der Verbindungspunkt der ersten und zweiten Dioden auf einem Spannungspegel gehalter wird, der durch den vorbestimmten Spannungspegel bestimmt ist, wenn die Intensität des einfallenden Lichtes eine vorbestimmte Größe übersteigt.

8. Festkörper-Bildaufnahmeapparat nach Anspruch 5, bei dem die Zelle ferner enthält:

einen Zwischenspeicherbereich zum Zwischenspeichern der durch das Schalterelement von der ersten Diode ausgelesenen Ladungssignale; und

ein Übertragungselement mit einer Elektrode zum Herausführen der Ladungssignale aus dem Zwischenspeicherbereich zum Erzeugen des Videosignals unter der Steuerung eines Übertragungsimpulses, der der Elektrode zugeführt wird, die mit der Steuerelektrode des Schalterelements verbunden ist.

9. Festkörper-Bildaufnahmeapparat nach Anspruch 8, bei dem die Amplitude des Ausleseimpulses größer als jene des Übertragungsimpulses ist.

10. Festkörper-Bildaufnahmeapparat nach Anspruch 8, bei dem die Amplitude des Leseimpulses gleich der des Übertragungsimpulses ist.

11. Festkörper-Bildaufnahmeapparat nach Anspruch 8, 9 oder 10, bei dem der Pegel der Vorspannung größer als jener des Übertragungsimpulses ist und der Verbindungspunkt der ersten Diode und des ersten Schalerelements auf einem vorbestimmten Spannungspegel gehalten wird, der von der Vorspannung bestimmt ist, wenn die Intensität des einfallenden Lichtes dabei ist, eine vorbestimmte Größe zu übersteigen.

12. Festkörper-Bildaufnahmeapparat nach einem der Ansprüche 5 bis 11,

bei dem die erste Diode von einem diffundierten Bereich gebildet ist, der in einem Halbleitersubstrat ausgebildet ist und eine entgegengesetzte Leitfähigkeitscharakteristik zu jener des Substrats aufweist;

und die zweite Diode von einem weiteren Bereich gebildet ist, der in oder auf dem diffundierten Bereich ausgebildet ist;

der Leseimpuls durch eine Gateelektrodeneinrichtung zugeführt wird, die auf einer isolierenden Schicht vorgesehen ist, die auf dem Substrat ausgebildet ist, und Ladungssignale ausliest, die in einer der ersten und zweiten Dioden gespeichert sind und deren Größe proportional der Menge des einfallenden Lichts ist; und

die Vorspannung von einer weiteren Elektrode zugeführt wird, der elektrisch mit dem anderen Bereich verbunden ist.

13. Festkörper-Bildaufnahmeapparat nach Anspruch 12, bei dem der andere Bereich einen Heterojunction-Photoleiter enthält, der auf dem diffundierten Bereich ausgebildet ist, um die Ladungssignale zu speichern.

14. Festkörper-Bildaufnahmeapparat nach Anspruch 12, bei dem der andere Bereich einen zweiten diffundierten Bereich enthält, der auf dem genannten diffundierten Bereich ausgebildet ist und eine zu jener des diffundierten Bereiches entgegengesetzte Leitfähigkeitscharakteristik aufweist, um die zweite Diode zu bilden.

15. Festkörper-Bildaufnahmeapparat nach Anspruch 12, 13 oder 14, bei dem das Potential des diffundierter Bereiches auf einem vorbestimmten Pegel gehalten wird, der von dem Pegel der genannten Vorspannung bestimmt wird, wenn die Menge des einfallenden Lichtes daran ist, eine vorbestimmte Größe zu übersteigen.

**Revendications**

1. Appareil de formation d'image à semi-

conducteurs comprenant un substrat et plusieurs cellules formées sur le substrat, qui accumulent des signaux de charges en réponse à l'intensité de la lumière incidente provenant d'un objet, en produisant un signal vidéo représentant une image optique de l'objet, en lisant les signaux de charge desdites cellules, dans lequel chacune desdites cellules comporte un élément photosensible (DN) et un élément de commutation (TR) qui est connecté audit élément photosensible et qui y lit les signaux de charge à la commande d'une impulsion de lecture (φR), appareil caractérisé en ce qu'il comporte en outre un dispositif agencé pour appliquer une impulsion de suppression de flou d'image (φBS) au point de connexion entre ledit élément photosensible (DN) et l'élément de commutation (TR) par un couplage capacitif, l'impulsion de suppression de flou d'image (φBS) étant synchronisée avec ladite impulsion de lecture (φR).

2. Appareil de formation d'image à semi-conducteur selon la revendication 1, dans lequel ledit élément photosensible consiste en un photoconducteur à hétérojonction qui constitue également ledit couplage capacitif.

3. Appareil de formation d'image à semi-conducteurs selon la revendication 1, dans lequel ledit couplage capacitif est constitué par un condensateur (C) qui couple le point de connexion avec ladite électrode.

4. Appareil de formation d'image à semi-conducteurs selon la revendication 1, 2 ou 3, dans lequel ledit élément de commutation (TR) consiste en un transistor à effet de champ.

5. Appareil de formation d'image à semi-conducteurs selon la revendication 1, dans lequel ledit élément photosensible (DN), consiste en une première diode qui comporte une capacité de jonction et qui y accumule les signaux de charges, et dans lequel une seconde diode qui comporte une capacité de jonction est connectée au point de connexion entre ladite première diode et ledit élément de commutation, le dispositif fournissant l'impulsion de suppression de flou d'image étant agencé de manière à fournir une tension de polarisation qui contient l'impulsion de suppression de flou d'image à l'une de ladite première et de ladite seconde diode.

6. Appareil de formation d'image à semi-conducteurs selon la revendication 5, dans lequel ladite première diode consiste en un photoconducteur à hétérojonction.

7. Appareil de formation d'image à semi-conducteurs selon la revendication 5 ou 6, dans lequel ladite tension de polarisation a un niveau de tension prédéterminé sauf dans l'intervalle de ladite impulsion de suppression de flou d'image, et le point de connexion entre ladite première et ladite seconde diode est verrouillé à un niveau de tension déterminé par le niveau de tension prédéterminée quand l'intensité de la lumière incidente dépasse une valeur prédéterminée.

8. Appareil de formation d'image à semi-conducteurs selon la revendication 5, dans lequel ladite cellule comporte en outre une région d'emmagasinage temporaire destinée à emmagasiner momentanément lesdits signaux de charge lus par ledit élément de commutation dans ladite première diode, et un élément de transfert comprenant une électrode pour transférer les signaux de charge de ladite région d'emmagasinage temporaire de manière à produire le signal vidéo à la commande d'une impulsion de transfert appliquée à l'électrode qui est couplée avec l'électrode de commande dudit élément de commutation.

9. Appareil de formation d'image à semi-conducteurs selon la revendication 8, dans lequel l'amplitude de l'impulsion de lecture est supérieure à celle de ladite impulsion de transfert.

10. Appareil de formation d'image à semi-conducteurs selon la revendication 8, dans lequel l'amplitude de ladite impulsion de lecture est égale à celle de ladite impulsion de transfert.

11. Appareil de formation d'image à semi-conducteurs selon la revendication 8, 9 ou 10, dans lequel le niveau de la tension de polarisation est supérieur à celui de ladite impulsion de transfert, et le point de connexion entre ladite première diode et ledit élément de commutation est verrouillé à une tension prédéterminée établie par ladite tension de polarisation quand l'intensité de la lumière incidente est sur le point de dépasser une valeur prédéterminée.

12. Appareil de formation d'image à semi-conducteurs selon l'une quelconque des revendications 5 à 11, dans lequel la première diode est constituée par une région diffusée qui est formée dans un substrat semi-conducteur et qui possède une caractéristique de conductivité opposée à celle dudit substrat, et la seconde diode est constituée par une autre région qui est formée dans ou sur ladite région diffusée, l'impulsion de lecture étant appliquée par une électrode de grille qui est prévue sur une couche isolante formée sur ledit substrat et qui lit des signaux de charge qui sont accumulés dans l'une de ladite première et ladite seconde diode et dont la valeur est en proportion de l'intensité de la lumière incidente, et la tension de polarisation étant appliquée par une autre électrode couplée électriquement avec ladite autre région.

13. Appareil de formation d'image à semi-conducteurs selon la revendication 12, dans lequel ladite autre région consiste en un photoconducteur à hétérojonction formé sur ladite région diffusée pour accumuler les signaux de charges.

14. Appareil de formation d'image à semi-conducteurs selon la revendication 12, dans lequel ladite autre région consiste en une seconde région diffusée qui est formée dans ladite région diffusée et qui possède une caractéristique de conductivité opposée à celle de ladite région diffusée pour former ladite seconde diode.

15. Appareil de formation d'image selon la revendication 12, 13 ou 14, dans lequel le potentiel de ladite région diffusée est verrouillé à un niveau prédéterminé, établi par le niveau de ladite tension de polarisation quand l'intensité de la lumière incidente est sur le point de dépasser une valeur prédéterminée.

*Fig. 1*

INCIDENT LIGHT

*Fig. 2*

1

0 029 367

Fig.3A

READ PULSE $\phi_R$

TRANSFER PULSE $\phi_T$

$V_{CH}$

$V_\phi$

$0$

Fig.3B

$V_C$

$0$

$V_L$

$\phi_{BS}$

Fig.3C

VOLTAGE DROP BY INCIDENT LIGHT

$V_3$

$V_2$

$V_c$

$0$

$V_1$

$\Delta V$

$T_0$ $T_1$ $T_2$ $T_3$ $T_4$ $T_0$

Fig.3D

$V_2$

$V_c$

$\Delta V'$

*Fig.4*

THE RATIO OF THE INTENSITY OF THE INCIDENT LIGHT TO THAT OF THE SATURATION EXPOSURE

*Fig.5A*

*Fig.5B*

3

*Fig.6A*

*Fig.6B*

TRANSFER DIRECTION

*Fig.7*

TRANSFER PULSE $\phi_{T0}$     READ PULSE $\phi_{RO}$